# EUROPEAN PATENT APPLICATION

(11) **EP 1 091 394 A2**
(43) Date of publication of application: **11.04.2001**
(21) Application number: 00121597.9
(22) Date of filing: 02.10.2000
(51) Int. Cl.: H01L 21/304, H01L 21/78, H01L 21/306

(54) **Method for manufacturing thin semiconductor chips**

(30) Priority: 04.10.1999 JP 28313999
(71) Applicant: TOKYO SEIMITSU CO.,LTD., Mitaka-shi Tokyo (JP)
(72) Inventor: Ishikawa, Toshihiko, Mitaka-shi, Tokyo (JP); Katagiri, Yasushi, Mitaka-shi, Tokyo (JP)
(74) Representative: Hering, Hartmut, Dipl.-Ing.

(57) **Abstract**

In a process of manufacturing semiconductor chips (C), first, the reverse of a wafer (W), on the obverse of which many chips (C) are formed, is ground so as to shape the wafer (W) with a predetermined thickness. Then, the reverse of the wafer (W) is polished or etched so that the broken layer which is formed during the back grinding is removed. Next, grooves (G) are formed on the obverse of the wafer (W) in a predetermined depth along streets (S) formed between the chips (C). Finally, the wafer (W) is cleft along the grooves (G) so as to be divided into separate chips (C). By this process, the broken layer formed on the reverse of the wafer (W) is removed after the back grinding, then the wafer (W) is divided into separate chips (C) by use of the cleavage; therefore, chipping is effectively reduced.

## Description

The present invention relates to a method for manufacturing semiconductor chips, particularly with extremely thin chips which are as thin as 200µm or less.

In manufacturing process of semiconductor chips, many semiconductor chips are formed on the obverse of a wafer such as a silicon wafer by processing the wafer by a predetermined manner, and the wafer is then diced with a dicing machine along streets, which are formed between the chips, to separate the chips.

Because of the increased number of smart cards, cellular phones and laptop personal computers, the semiconductor chips that are assembled into small devices have been required to be light-weighted and small-sized.

In view of such requirements, after forming the chips on the obverse of the wafer, the reverse of the wafer is ground by a planarization apparatus so as to make the wafer thin, and then the wafer is diced to separate chips by the dicing machine. In this dicing, the dicing machine performs a full-cut (a processing method for completely cutting and dividing the wafer) for the wafer along the streets so as to separate the chips.

However, a broken layer (also called a spoiled layer or a damaged layer) is formed on the reverse of the wafer during the reverse face grinding, and the broken layer causes breakage of the extremely thin wafer with the thickness of 200µm or less in the process afterwards. Moreover, when completely cutting the extremely thin wafer by the full-cut with the dicing machine, many inferior chips are generated due to chipping (crack) on the reverse of the wafer.

The present invention has been developed in view of the above-described circumstances, and has as its object the provision of a method of manufacturing the semiconductor chips by which extremely thin semiconductor chips can be manufactured without generating cracks or chipping.

In order to achieve the above-described objects, the present invention is directed to a method for manufacturing semiconductor chips, comprising the steps of: grinding a reverse of a wafer so as to shape the wafer in a predetermined thickness, the chips being formed on an obverse of the wafer; processing, by at least one of polishing and etching, the reverse of the wafer so as to remove a broken layer formed on the reverse of the wafer in the grinding step; forming grooves on the obverse of the wafer in a predetermined depth along streets formed between the chips; and cleaving the wafer along the grooves so as to separate the chips.

According to the present invention, first, the reverse of a wafer, on the obverse of which many chips are formed, is ground so as to shape the wafer with a predetermined thickness. Then, the reverse of the wafer is polished or etched so that the broken layer which is formed during the back grinding is removed. Next, grooves are formed on the obverse of the wafer in a predetermined depth along streets formed between the chips. Finally, the wafer is cleaved along the grooves so as to be divided into separate chips. By polishing or etching the reverse of the wafer after the back grinding so as to remove the broken layer formed during the back grinding, the strength of the chips is improved. Moreover, by dividing the wafer from which the broken layer is removed into separate chips by using the cleavage, cracks and chipping of the reverse of the wafer are effectively reduced.

### BRIEF DESCRIPTION OF THE DRAWINGS

The nature of this invention, as well as other objects and advantages thereof, will be explained in the following with reference to the accompanying drawings, in which like reference characters designate the same or similar parts throughout the figures and wherein:
Fig. 1 is a flowchart showing a method of manufacturing semiconductor chips according to an embodiment of the present invention;
Fig. 2 is an explanatory view of a back grinding process;
Fig. 3 is a perspective view showing a protecting sheet which is adhered to the obverse of a wafer;
Fig. 4 is an explanatory view of a polishing process;
Fig. 5 is an explanatory view of a dicing process;
Fig. 6 is another explanatory view of the dicing process;
Fig. 7 is an explanatory view of a breaking process;
Fig. 8 is another explanatory view of the breaking process;
Fig. 9 is an explanatory view of a pick-up process; and
Fig. 10 is an explanatory view of a scribing process.

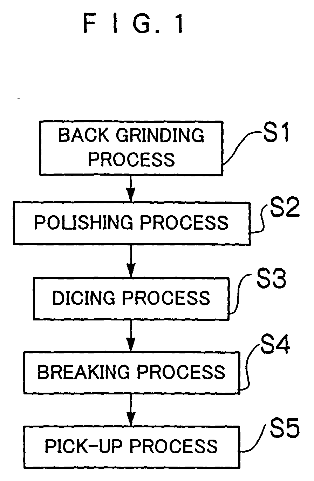

Fig. 1 is a flowchart of a method of manufacturing semiconductor chips of the present invention. As shown in Fig. 1, a wafer W on the obverse of which many chips are formed, is processed and divided to separate chips through a reverse (back face) grinding process (step S1), a polishing process (step S2), a dicing process (step S3), a breaking process (step S4), and a pick-up process (step S5).

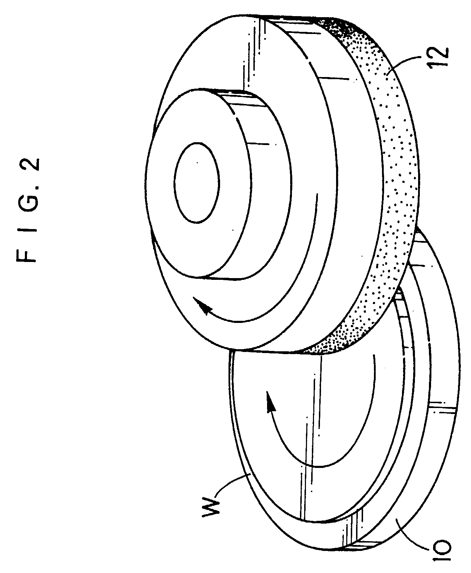

In the back grinding process (step S1), the reverse of the wafer W on the obverse of which many chips are formed is ground so that the wafer W has a predetermined thickness. As shown in Fig. 2, in the back grinding process, the obverse of the wafer W (the face on which the chips are formed) is held by suction by a chuck table 10 and is rotated, then the reverse of the wafer W is ground by pressing a rotating grinding wheel 12 against the reverse of the rotating wafer W.

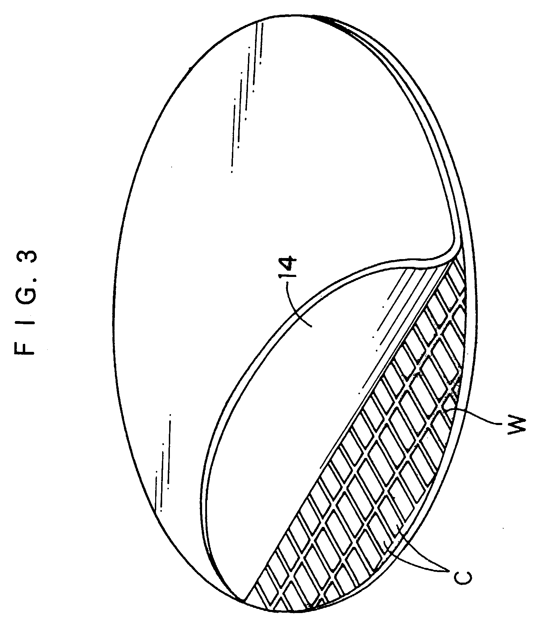

As shown in Fig. 3, a protecting sheet 14 is adhered to the obverse of the wafer during the processes in order to protect chips C, C, ..., which are formed on the obverse of the wafer W. Thereby, the chips C are protected from stains and damages caused by holding the obverse of the wafer W by suction by the chuck table 10.

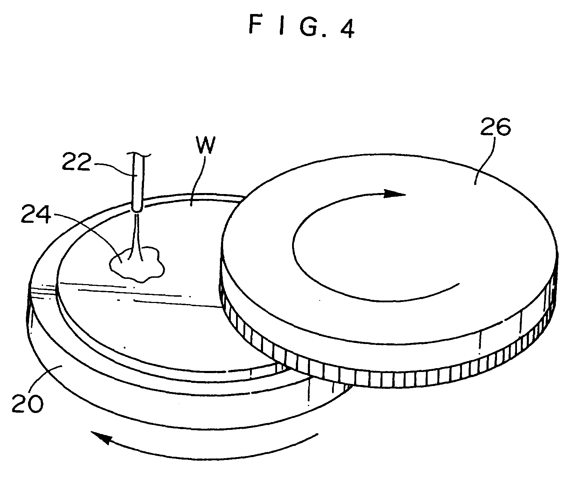

In the polishing process (step S2), the reverse of the wafer W is polished so that a broken layer, which is formed on the reverse of the wafer W during the back grinding, is removed. As shown in Fig. 4, in the polishing process, the obverse of the wafer W is held by suction by a chuck table 20 and is rotated, then the reverse of the wafer W is polished by pressing a rotating polishing pad 26 against the wafer W while supplying slurry 24 from a nozzle 22 to the reverse of the rotating wafer W.

The wafer W is processed in the polishing process in the state where the protecting sheet 14 is adhered to the obverse of the wafer W in order to protect the chips C, C, ... on the obverse of the wafer W.

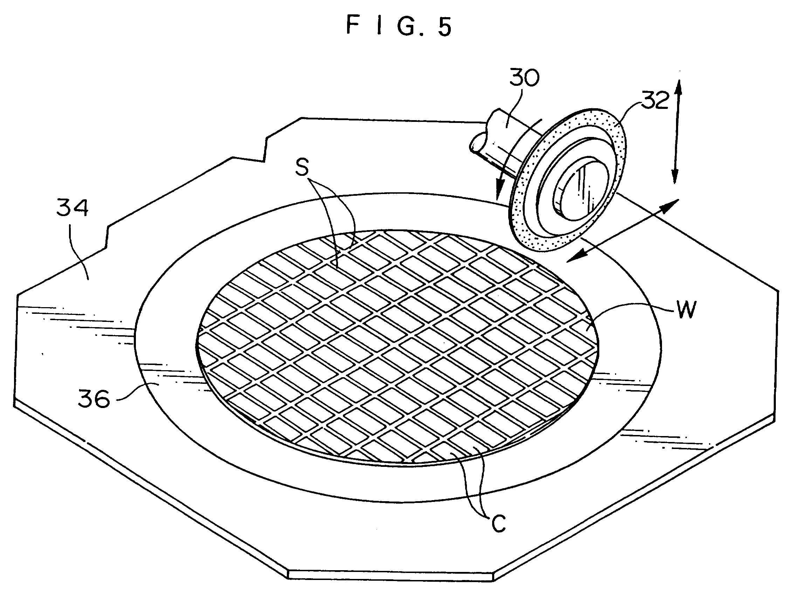

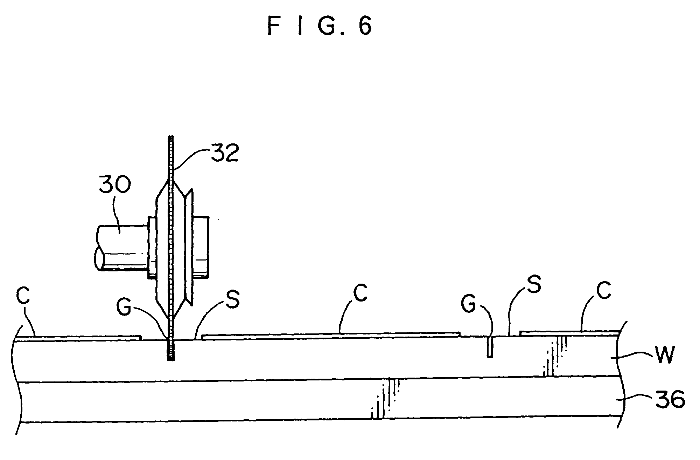

In the dicing process (step S3), grooves in a predetermined depth are formed on the obverse of the wafer W along streets S, which are formed between the chips C, C, ... As shown in Figs. 5 and 6, in the dicing process, cutting grooves G are formed on the wafer W along the streets S by an extremely thin outer peripheral blade (dicing blade) 32, which is attached to the end of a spindle 30 rotated at a high speed. In short, the cutting grooves G in the predetermined depth are formed along the streets S without completely dividing the wafer W.

As shown in Fig. 5, the wafer W is processed while being mounted on a wafer frame 34, and a wafer sheet 36 is adhered to the inner periphery of the wafer frame 34. The wafer sheet 36 is an adhesive plastic sheet, and the wafer W is mounted on the wafer frame 34 by adhering the reverse of the wafer W to the wafer sheet 36.

The protecting sheet 14 is adhered to the obverse of the wafer W through the back grinding process (step S1) and the polishing process (step S2); hence, the process to form the cutting grooves G is performed after separating the protecting sheet 14 from the obverse of the wafer W.

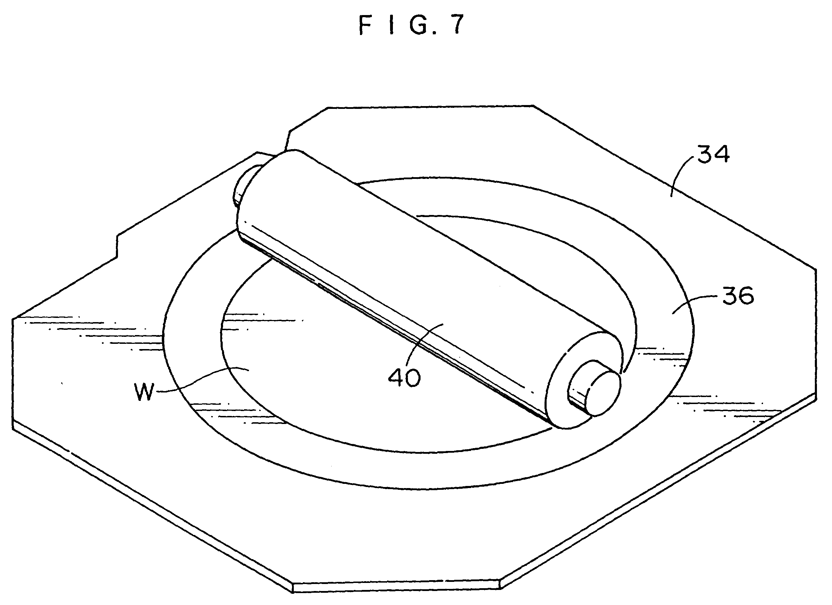

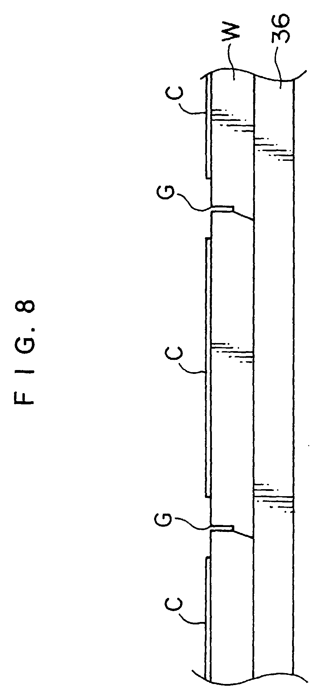

In the breaking process (step S4), the wafer W is cleft along the cutting grooves G, which are formed on the obverse of the wafer W in the dicing process, so as to divide the wafer W into separate chips C, C, ... As shown in Fig. 7, in the breaking process, a rubber roller 40 is pressed against the reverse of the wafer W, which is held in the wafer frame 34, and the wafer W is cleaved into separate chips C by moving the rubber roller 40 over the wafer W. In other words, when the reverse of the wafer W is pressed by the rubber roller 40, splits develop along the cutting grooves G, which are previously formed, as shown in Fig. 8, and the wafer W is divided into separate chips along the splits. In short, the wafer W is divided into separate chips by using cleavage.

Since the cleavage develops along a cleavage plane, which is determined by a direction of the crystal axis of the wafer W, the wafer W is divided into chips with smooth surfaces and also with less chipping.

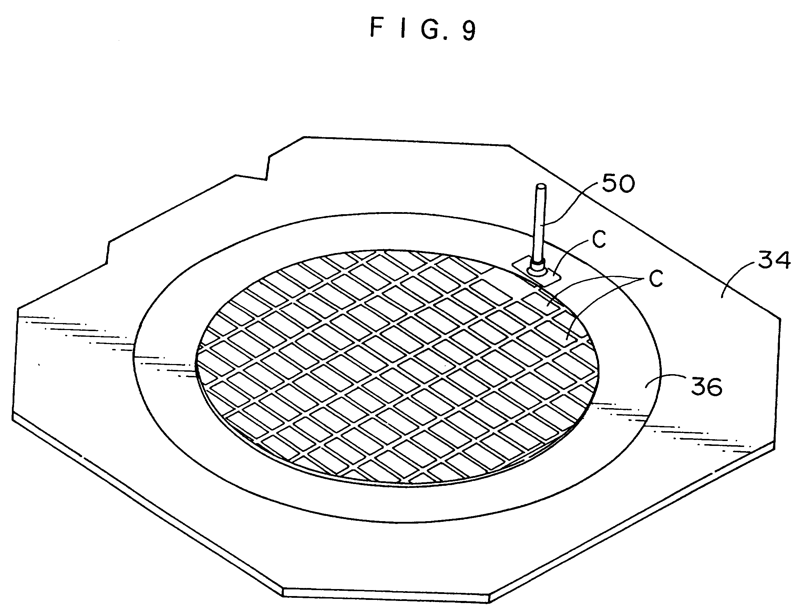

In the pick-up process (step S5), the chips C, C, ..., which are separated in the breaking process, are collected from the wafer frame 34. At the beginning of this process, the wafer sheet 36 is irradiated with ultraviolet light from the reverse of the wafer frame 34. By the irradiation, the adhesive of the wafer sheet 36, to which the chips C, C, ... are adhered, is hardened, and the chips C can be separated from the wafer sheet 36. Then, as shown in Fig. 9, the chips C are collected one after another by a suction pad 50, and the chips C are rearranged on a tray (not shown). In this process, only the chips C with good quality are picked up and collected.

As described above, in the method of manufacturing the semiconductor chips of the present embodiment, the reverse of the wafer W is polished after grinding the reverse of the wafer W to make the wafer W thin, thereby the broken layer, which is formed during the back grinding, is removed, and the wafer W is divided into separate chips C, C, ... by using the cleavage. Thus as presented, since the reverse of the wafer W, which is ground to make the wafer W thin, is polished so that the broken layer of the wafer W is removed, the strength of the chips is improved. Moreover, chipping at the reverse of the wafer W can be effectively prevented from being generated by dividing the wafer W with no broken layer into chips using the cleavage.

In particular, if the wafer W is processed as thin as 200µm or less by the back grinding process, many cracks and chipping are generated on the chips by completely cutting (full-cut) the wafer W in the dicing process. However, by dividing the wafer W into chips using the cleavage after removing the broken layer, the cracks and chipping on the chips can be effectively prevented.

The present embodiment uses a method of polishing the reverse of the wafer W to remove the broken layer; however, the broken layer may be removed by etching. In the etching process, the obverse of the wafer W is held by suction by a chuck table and rotated, and the reverse of the wafer W is etched by supplying etching liquid from a nozzle to the reverse of the wafer W (so-called spin etching).

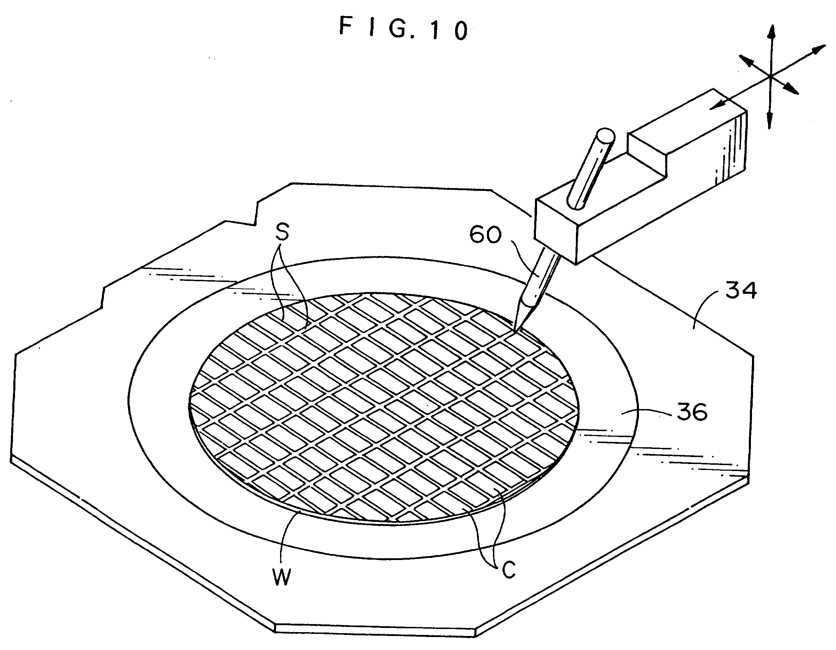

The present embodiment uses the extremely thin outer peripheral blade (dicing blade) 32 to form the cutting grooves G along the streets S on the wafer W; however, a scribing device may also be used. As shown in Fig. 10, grooves in the predetermined depth are formed by scratching the obverse of the wafer W along the streets S with a diamond point cutter 60, and at the same time strain is generated inside the wafer W by the concentrated stress, so that the wafer W can be easily cleft. This scribing device achieves a manufacturing process with a dry process and an inexpensive machine.

In types of wafers W with streets on which test patterns and so forth are partially formed, the cutter of the scribing device cannot sufficiently generate the strain inside the portions where the test patterns are formed, and thus the wafer W cannot be well-cleft. In order to solve this problem, shallow grooves are formed on the surface of the streets by the dicing blade of the dicing device, and the bottom of the shallow grooves are scratched with the scribing cutter of the scribing device, whereby the wafer W can be clearly cleft by the breaking process afterwards.

Moreover, to present a method of cleaving the wafer W into separate chips in the present embodiment, the rubber roller 50 is pressed against the reverse of the wafer W and is moved over the reverse of the wafer W. However, other alternative methods such as developing splits by tugging the wafer sheet 36, to which the wafer W is adhered, in side directions, or developing splits by pushing chips C one after another from the reverse of the wafer W.

In the present embodiment, cleaning of the wafer W is not mentioned; however, when transporting the wafer W between the processes, it is preferable to transport the wafer W after being cleaned and dried.

As described hereinabove, in the method of manufacturing the semiconductor chips of the present invention, the reverse of the wafer is ground first and is polished or etched whereby the broken layer, which is formed during the back grinding, is removed. Thus, the strength of the chips is improved. Furthermore, by dividing the wafer W with no broken layer into separate chips using the cleavage, cracks and chips can be effectively reduced.

It should be understood, however, that there is no intention to limit the invention to the specific forms disclosed, but on the contrary, the invention is to cover all modifications, alternate constructions and equivalents.

## Claims

1. A method for manufacturing semiconductor chips (C), comprising the steps of:
grinding a reverse of a wafer (W) so as to shape the wafer (W) in a predetermined thickness, the chips (C) being formed on an obverse of the wafer (W);
processing, by at least one of polishing and etching, the reverse of the wafer (W) so as to remove a broken layer formed on the reverse of the wafer (W) in the grinding step;
forming grooves (G) on the obverse of the wafer (W) in a predetermined depth along streets (S) formed between the chips (C); and
cleaving the wafer (W) along the grooves (G) so as to separate the chips (C).

2. The method as defined in claim 1, wherein the groove forming step comprises the step of grooving the obverse of the wafer (W) in the predetermined depth along the streets (S) with a dicing blade (32) to form the grooves (G).

3. The method as defined in claim 1 or 2, wherein the groove forming step comprises the step of scratching the obverse of the wafer (W) along the streets (S) with a scribing cutter (60) to form the grooves (G).

4. The method as defined in claim 1, 2 or 3 wherein the groove forming step comprises the steps of:
grooving the obverse of the wafer (W) in the predetermined depth along the streets (S) with a dicing blade (32) to form the grooves (G); and
then scratching bottoms of the grooves (G) with a scribing cutter (60).
